Europäisches Patentamt

European Patent Office

Office européen des brevets

(19)

(11) Publication number: **0 125 133 B1**

(12) **EUROPEAN PATENT SPECIFICATION**

(45) Date of publication of patent specification: **16.10.91**  (51) Int. Cl.⁵: **H01L 21/324, H01L 21/31**

(21) Application number: **84303061.0**

(22) Date of filing: **08.05.84**

(54) **A method of etching for use in semiconductor device fabrication.**

(30) Priority: **09.05.83 JP 80503/83**

(43) Date of publication of application:
**14.11.84 Bulletin 84/46**

(45) Publication of the grant of the patent:
**16.10.91 Bulletin 91/42**

(84) Designated Contracting States:
**DE FR GB**

(56) References cited:
**EP-A- 0 034 483**
**US-A- 4 415 606**

**PROCEEDINGS OF THE 7TH CONFERENCE
ON SOLID STATE DEVICES, TOKYO, 1975,
SUPPLEMENT TO JAPANESE JOURNAL OF
APPLIED PHYSICS, vol. 15, no. 7, 1976, pages
13-18, Tokyo, JP; Y. HORIIKE et al.: "A new
chemical dry etching"**

**THIN SOLID FILMS, vol. 67, no. 2, April 1980,
pages 229-232, Elsevier Sequoia S.A., Lau-
sanne, CH; M. ANDRASI: "Etched profile con-
trol in photolithographic pattern etching"**

(73) Proprietor: **FUJITSU LIMITED**
**1015, Kamikodanaka Nakahara-ku
Kawasaki-shi Kanagawa 211(JP)**

(72) Inventor: **Takada, Tadakazu c/o Fujitsu Limit-
ed**
**Patent Department 1015, Kamikodanaka
Nakahara-ku
Kawasaki-shi Kanagawa 211(JP)**

(74) Representative: **Sunderland, James Harry et al
HASELTINE LAKE & CO Hazlitt House 28
Southampton Buildings Chancery Lane
London WC2A 1AT(GB)**

## Description

The present invention relates to a method of etching for use in semiconductor device fabrication.

When fabricating multi-layer wirings for a semiconductor device, it is important to obtain a good "step coverage", in order to attain high device reliability. "Step coverage" is concerned with the ability to cover continuously a stepped portion with a layer overlying or covering the stepped portion. Step coverage is especially important in IC processing technology in relation to the fabrication of contact wiring between circuits fabricated on surfaces of different levels or heights. Such wiring between surfaces on different levels, or connections between different level wiring layers of multilayer wiring, increasingly occurs in large scale integration circuits (LSI), as the scale of integration increases. Contact holes, through which wiring or connections between different level layers or surfaces are established, are typical cases in which steps arise.

A conductive layer (generally of aluminium film) formed on a surface having a step becomes thin where it covers the step, especially when the step has a sharp edge, and breakages in wiring (discontinuities in the conductive layer) frequently arise at such steps. It is highly desirable to maintain a constant thickness of the conductive layer where it covers a step; that is, to obtain a good step coverage, in order to attain a high reliability of an IC.

In order to obtain a good step coverage, usually a stepped portion is formed so as to be tapered or sloping. Tapering of a step is provided in an etching process.

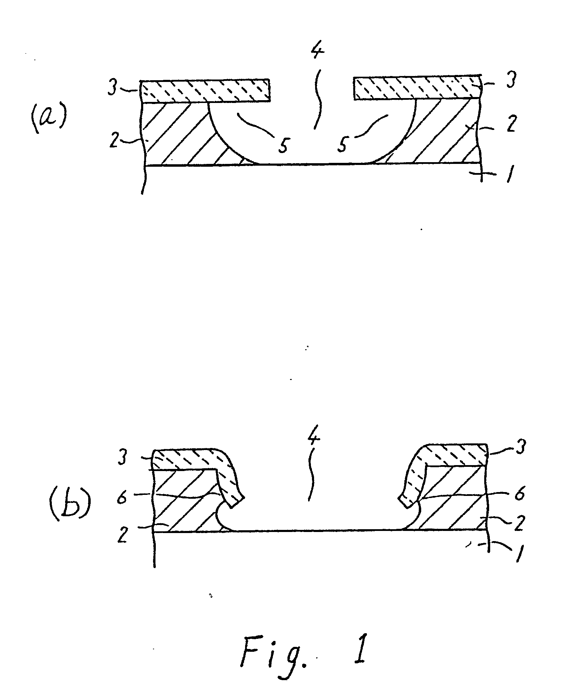

For example, Fig. 1 (a) of the accompanying drawings is a schematic cross-sectional view of a contact hole fabricated by a previous plasma etching process. In Fig. 1(a), 1 is an aluminium layer, part of a first (lowest) wiring layer, which is fabricated over a substrate (not shown), and 2 is an insulating layer on which a second wiring layer (not shown) is to be fabricated.

The insulating layer 2 is covered with a photo resist mask 3 which has in it a pattern for formation of a contact hole 4, which pattern is fabricated by photo-lithographic technology.

The masked substrate (layer 2) is etched by plasma etching. Usually, a mixture of tetrafluoromethane ($CF_4$) and oxygen ($O_2$) is used as etchant gas.

By this plasma etching process, a portion of the insulating layer 2 which is exposed through the photo resist mask 3 is etched off, and the contact hole 4 is formed. During this plasma etching process, as shown in Fig. 1(a), the insulating layer 2 is side etched, and an undercut portion 5 is generated.

This under-cut portion is tapered naturally and is desirable from the view point of providing good step coverage. The previous technology depends on the presence of such under-cuts.

However, in the previous process the formation of overhangs where insulating layers are side etched is a frequent problem.

If etching temperature is raised in order to increase etching rate, the photo resist mask 3 is heated by plasma and softened. Accordingly, the mask folds or tilts down as shown in the schematic cross-sectional view of Fig. 1(b) of the accompanying drawings. If such folding or tilting of resist occurs in the middle of etching, the etching process continuing after it occurs, the etched insulating layer 2 has an overhang 6, as shown in Fig. 1-(b). Although etching rate might be reduced then to a low rate in order to avoid heating of the photo resist, the overhang still remains.

Turning back to Fig. 1(a), although the bottom part of the side wall of the contact hole 4 at the undercut 5 is tapered with a relatively gentle slope, the slope of the upper part of the side wall at the undercut (close to the photo resist 3) is very steep (and sometimes has an overhang) because the insulating layer near the bottom side of the resist is not etched so well.

The previous etching process as illustrated in Fig. 1(a) and (b), cannot avoid problems of poor step coverage, and IC reliability has often suffered as a result.

In etching for semiconductor device fabrication, a shift is taking place from batch processing to continuous processing on a conveyor system, providing for mass production. In batch processing, a plurality of slices (substrates) are processed in a batch and accordingly, a slow etching rate need not adversely affect total processing speed. On the other hand, in a continuous processing system, etching rate is an important factor determining production speed. High etching rate, therefore, is required for continuous processing.

Proceedings of the 7th Conference on Solid State Devices, Tokyo, 1975, Supplement to the Japanese Journal of Applied Physics, Vol. 15, No. 7, 1976, pages 13 to 18, in an article entitled "A New Chemical Dry Etching", discloses a chemical dry etching technique, in which a reaction region and a gas discharge region are separated. $CF_4$ and $O_2$ are used as reaction gases. A sample wafer is placed in a reaction region, to which region active species created by discharge of $CF_4$-$O_2$ mixture are transported from a discharge region. Exposure of the sample wafer to plasma is avoided.

In one example (c.f. Fig. 7 of the article) a sample silicon wafer, with 1 $\mu$m poly-Si layer and a photoresist mask on its obverse side, is etched.

The reaction region is kept at room temperature and the wafer sample temperature, measured at its reverse side surface, reaches about 74°C during etching.

The technique of the article is said to have the advantage that the surface temperature of wafers can be kept below 80°C.

The article discusses temperature dependence of etching rates of poly-Si and $SiO_2$, using the technique of the article, over a temperature range 25°C to 220°C (c.f. Fig. 6 of the article).

According to the present invention there is provided a method of etching, for use in semiconductor device fabrication, in which a substrate body having a layer to be etched on its obverse side with a photo resist mask on the layer through which a part of the layer is exposed is

heated from its reverse side to a temperature at which the photo resist mask is softened, and

supplied with active etchant gas at a temperature lower than that at the obverse side of the substrate body for etching the exposed part of the layer at the obverse side such that during etching an edge of the photo resist mask a round the exposed part of the layer curls upwards away from the layer.

An embodiment of the present invention can provide a method of etching for semiconductor device fabrication which can give good step coverage for example for multi-layered wiring.

An embodiment of the present invention can provide an etching method which does not adversely heat up a photo resist mask but which offers a high etching speed.

In an embodiment of the present invention a dry etching process for example a chemical dry etching process, is applied to substrate or layer, which is heated from its reverse side opposite to its obverse side at which etching takes place.

The plasma used for chemical dry etching is not of such a high temperature and a photo resist mask employed is not adversely heated up to its softening point by the plasma. On the other hand, the substrate is heated from its back or reverse side. The result is that, as etching proceeds, an edge of the photo resist mask rolls or curls upwardly (away from the substrate). This is thought to be due to differential thermal expansion between upper (away from the substrate) and lower sides of the photo resist film. Side etching occurs under this up-heaved or up-curled portion of the photo resist mask, and a step formed in correspondence to the edge of the mask (for example the side wall of a contact hole) is tapered in such a way as to allow a good step coverage to be achieved.

The etching speed offered by chemical dry etching is high, and it is applicable to continuous processing on a conveyor system.

An embodiment of the present invention is especially applicable to fabrication of a contact hole in an insulating layer separating multi-level metallizations of an integrated circuit (IC).

Reference is made, by way of example, to the accompanying drawings, in which:-

Fig. 1(a) is a schematic cross-sectional view showing a contact hole fabricated by previous technology,

Fig. 1(b) is a schematic cross-sectional view showing formation of an overhang at a contact hole fabricated by previous technology,

Fig. 2 is a series of schematic cross-sectional views illustrating a process for forming a contact hole in an insulating layer between multi-layer wiring layers of a semiconductor device, using an etching method embodying the present invention, and

Fig. 3 schematically illustrates apparatus for an etching system for continuous processing of semiconductor slices carried continuously on a conveyor system, using an etching method embodying the present invention.

As mentioned above, in an ordinary plasma etching process the photo resist mask is heated up by the plasma. The softening points of ordinary photo resist are approximately 120°C for positive resist (for example, OFPR series resist sold by TOKYO OHKA KOGYO), and 160°C for negative photo resist (for example, OMR series resist sold by TOKYO OKHA KOGYO). In an ordinary plasma etching process, if etching rate is increased, the photo resist mask is heated up to a temperature above its softening point. Accordingly, the mask tilts or folds down as shown in Fig. 1(b), and an overhang on the side wall of the contact hole results, with consequent poor step coverage subsequently.

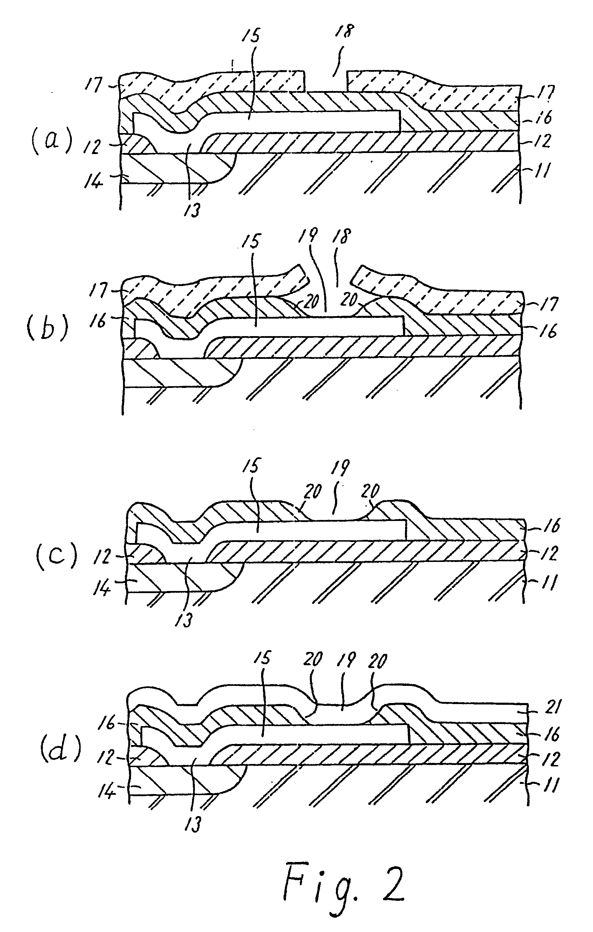

In an embodiment of the present invention low temperature plasma is used and a substrate body, on which a layer to be etched is formed, is heated from its reverse side (opposite to its obverse side at which etching takes place), in order to roll or curl up an edge of a photo resist mask corresponding to a step to be formed (e.g. close to a side wall of a contact hole to be formed). Fig. 2 illustrates inter alia etching as accomplished by an embodiment of the present invention.

An example will now be given in relation to a case in which a contact hole is to be formed in a semiconductor device having multi-layered wiring.

An etching process embodying the present invention can be carried out on an ordinary semiconductor device, using a substrate already processed by ordinary methods to fabricate elements of devices such as bipolar or MIS (Metal Insulator Semiconductor) structure devices. For example a first wiring layer (a lower wiring layer) over the substrate, and an insulating layer covering the substrate (the lower wiring layer) are also fabricated on the surface of the substrate.

Fig. 2(a) is a schematic cross sectional view of such a substrate, which is ready for etching, in a region close to a location where a contact hole is to be formed in the insulating layer. Preparation of the substrate for etching will be described briefly.

In Fig. 2(a), 11 is the substrate in which semiconductor device elements such as transistors or FETs are already fabricated. The surface of the substrate is generally coated by a passivation film (not shown), such as a silicon dioxide ($SiO_2$) film. A phospho-silicate glass (PSG) layer is then fabricated by ordinary chemical vapour deposition (CVD), over the substrate 11. In Fig. 2(a), lower insulating layer 12, which is usually made up of the $SiO_2$ film and the PSG layer mentioned above, is provided with a contact hole 13 for an electrode 14 by ordinary reactive ion etching (RIE) and photo-lithography. Usually, tetrafluoromethane ($CF_4$), for example, is applicable as the etchant for the RIE. The edge of the contact hole 13 is smoothed and tapered as seen in Fig. 2(a) by an ordinary reflow process.

Reflowing is a process for smoothing the etched surface of the PSG layer, it is achieved by heating the substrate up to about 900°C for about 30 minutes in dry oxygen ambient. This rounds the edge of contact hole 13 as shown. However, this process cannot be applied to a second insulating layer, or further higher multiple layers. The temperature needed is so high that wiring layers would be damaged.

Following the reflow process, by ordinary plasma sputtering, for example, aluminium film is coated over the lower insulating layer 12. This film is patterned as a first wiring layer, by ordinary photo-lithography using gas etchant including chlorine. Thus, a first wiring layer 15 contacting active area 14 of a semiconductor element is fabricated.

Sometimes a poly-crystalline silicon (poly-silicon) layer is formed under the first wiring layer 15 (not shown).

Then, a PSG insulating layer 16 of 1 $\mu$m thickness, for instance, is formed by ordinary chemical vapour deposition process over the first wiring layer 15. The PSG insulating layer 16 is coated with a photo resist film 17, e.g. a positive photo resist film of 1.5 $\mu$m thickness. In the photo resist film 17 is opened a contact hole pattern 18, by ordinary photo-lithography. The above-described processes are ordinary processes for fabricating semiconductor devices. It will be understood that any modified or alternative processes for fabricating a semiconductor device having multi-layered wiring can be substituted.

It will be appreciated also that the present invention can be applied in cases other than the formation of a contact hole in a device having multi-layered wiring.

Returning to Fig. 2, in the next step an etching method in accordance with an embodiment of the present invention is performed on the substrate prepared in above described manner.

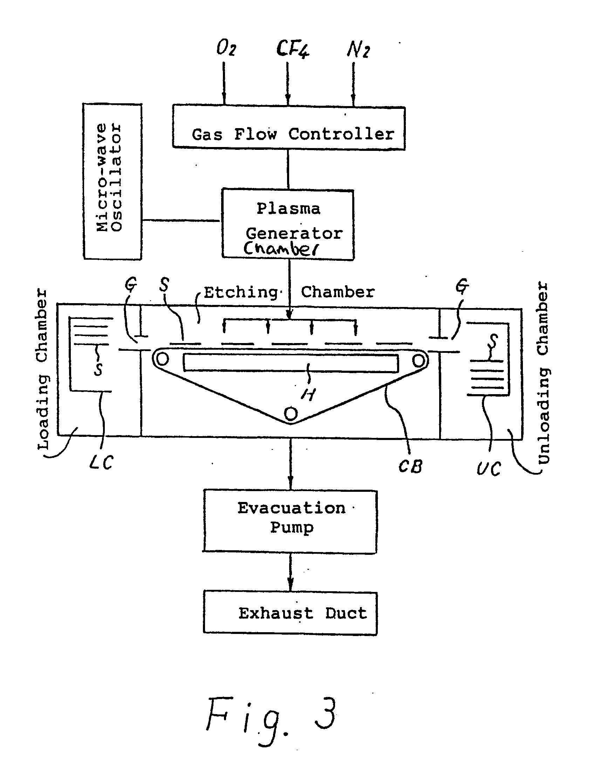

Fig. 3 shows schematically an example of chemical dry etching equipment for performing etching in accordance with an embodiment of the invention. In this equipment etching is performed slice (substrate) by slice on a conveyor system.

As shown in Fig. 3, a plurality of slices S are loaded on a loading cassette LC, and inserted into a loading chamber. In the loading chamber, air is pumped out and gas pressure is selected so as not to disturb gas pressure in an etching chamber of the equipment. Then, the slices are loaded one by one onto a conveyor belt CB through a gate G, which gate is shut until the gas pressure in the loading chamber is as selected to avoid disturbance. Means for performing these operatins are not shown, for the sake of simplicity. Any means can be used.

In the etching chamber each slice is heated from its reverse or back side by a heater H placed below the conveyor belt CB, and etched by plasma reactive gas (from its front side). The etching process will be described below.

After etching is finished, slices are unloaded from the conveyor belt, and loaded onto an unloading cassette UC by suitable means (not shown). When the unloading cassette is filled with slices S, a further gate G shuts the unloading chamber off from the etching chamber, and the etched slices are taken out from the unloading chamber after the gas in the unloading chamber has been replaced by air.

During loading of cassettes into the loading chamber and unloading of cassettes from the unloading chamber, the etching process is interrupted in the illustrated equipment. However, it will be clear for one skilled in the art that the equipment of Fig. 3 can be modified to make it possible to continue the etching process whilst the cassettes are being loaded or unloaded. For example, adding an additional loading chamber and an additional gate to the left side of the loading chamber in Fig. 3, and adding one more unloading chamber and another gate to the right side of the unloading chamber in Fig. 3, will make it possible to load or unload the cassettes to or from these extra chambers, and to establish suitable gas pressure conditions, whilst the other chambers are in operation. When a loading cassette or an unloading cassette is empty or full of slices, it can be replaced by a new cassette in the loading or unloading chamber without disturbing the operations being performed in the etching chamber. It will be appreciated that many other modifications of operations, equipment and means can be effected.

In accordance with a method embodying the present invention selective etching of the insulating layer 16 to fabricate the contact hole therein is performed by a chemical dry etching using the photo resist mask 17. The etchant gas is a mixture of tetrafluoromethane ($CF_4$) and oxygen ($O_2$), for example. In the equipment of Fig. 3, etchant gas flow is controlled by a gas flow controller. The mixing ratio of $CF_4$ and $O_2$ is 80:20 in terms of flow rate, for example. In the equipment of Fig. 3, the etchant gas mixture is fed into a plasma generator chamber, where the etchant gas is excited and activated by microwaves supplied from a microwave oscillator and a plasma of the etchant gas is generated. Usually the microwave power used is about 1kW and the microwave frequency is about 2.45 GHz, generated by the microwave oscillator (generator) and fed into the plasma generating chamber. The etching chamber is evacuated by an evacuation pump to an exhaust duct, in order to maintain a constant pressure of 40 Pa (0.3 Torr), for example, in the etching chamber. The plasma is then fed into the etching chamber, and etches the substrate.

Usually, plasma etching is performed in a chamber into which a substrate is introduced, and etchant gas led into the chamber, and microwave power is fed into the chamber. In such a case the substrate is heated by the microwaves and by heated gas which is not activated to plasma. However, in plasma etching as described above, the place for plasma generation (plasma generator chamber) and the place for etching (etching chamber) are separated. Accordingly, a substrate is not heated as much as in ordinary plasma etching. Such plasma etching is called chemical dry etching. Further details of dry etching using plasma are given for example in "Glow Discharge Processes" by Brian Chapman, published in 1980 by John Wiley & Sons. Inc. N.Y. U.S.A.

In the etching chamber shown in Fig. 3, the substrates S are heated from their back surfaces by the heater H placed below the conveyor belt CB. The temperature is controlled to 120 to 160°C when a positive photo resist is used for the mask 17. This temperature is such that positive photo resist is softened. If a negative photo resist is used for the mask 17, the temperature is increased to 160 to 200°C, at which negative photo resist is softened.

At the same time, chemical dry etching proceeds from the upper or front or obverse surface of substrate through the hole pattern 18 in the photo resist film 17. Etching rate is approximately 300nm/min (3,000 A°/minute).

During such etching, it was found by the inventor that the edge of the photo resist layer 17 is rolled or curled up gradually as side etching proceeds, as shown in Fig. 2(b). The reason for this is believed to be that the temperature of the upper surface of the photo resist film 17 is lower than that of its lower surface, because the effective temperature of the plasma is lower than that of the surface of the substrate. Therefore, due to a difference of in thermal expansion of the two sides of the photo resist film, it rolls or curls up at its edges.

Though, it is difficult to measure the temperature of plasma, and the explanation given above for the rolling or curling up phenomenon should be regarded as a tentative explanation, the phenomenon certainly takes place and affords an advantageous form of tapering for a side wall 20 of an etched hole 19 as seen in Fig. 2(b). Under the given conditions, under-cutting and side etching extend more widely (i.e. extend laterally further) as etching towards the bottom of the etching hole (19) proceeds. Thus, the etched contact hole 19 is provided naturally with gently tapering side walls as shown in Fig. 2(c), which shows a cross sectional view corresponding to Fig. 2(b), after the etching is finished and the photo resist mask 17 has been removed. Gentle tapering is provided both at the bottom part of a side wall and at an upper part of the side wall. The shape of contact hole achieved is very suitable for attaining good step coverage.

After the contact hole 19 has been fabricated, an upper wiring layer and a surface protection layer are fabricated to finish the substrate. The processes are similar to ordinary semiconductor processes, and any process suitable for these purposes can be employed. One example of such a process will be described briefly.

As shown in Fig. 2(d), over the substrate, in which contact hole fabrication is completed (and after removal of the photo resist mask 17 as shown in Fig. 2(c)), an aluminium film of approximately 1.5 $\mu$m thickness is fabricated by plasma sputtering for example. Then, by a photo-lithographic process, the aluminium film is patterned to form a second (upper) wiring circuit 21, by reactive iron etching (RIE), for example, using a gas containing chlorine ($Cl_2$) as an etchant. Thus, the upper wiring circuit 21 is connected to the first wiring circuit 15, through the contact hole 19.

Since a side wall 20 of the contact hole 19 is tapered gently as described above, the step coverage of the upper aluminium layer is very good: consequently there appear no dislocations in the aluminium film of the upper wiring circuit over the contact hole 19. After this process, the surface of the substrate is coated with an insulation layer (not shown) for surface protection, and the entire substrate is finished.

Above, the insulating layer between the conductive layers (wiring layers) was assumed to be a phospho-silicate glass (PSG), but it can be any kind of insulating layer, for example a silicon dioxide ($SiO_2$) layer formed by chemical vapour deposition (CVD) or a silicon nitride ($Si_3N_4$) film formed by plasma deposition process. The wiring layers maybe of any kind: for example poly-crystalline silicon, or metal silicide and so on may be employed. Also the material of the semiconductor is not limited in the silicon, it may be germanium or a compound semiconductor for example.

Although the above description relates to fabrication of a contact hole, it will be clear that etching methods embodying the present invention can be applied for etching of any appropriate part of a semiconductor device.

As has been described above, by applying an etching method embodying the present invention, the side walls of a contact hole in an insulating layer between two conducting layers are tapered gently and accordingly coverage over the contact hole is improved, and disconnection over the contact hole is avoided. Consequently, device reliability and production yield are increased.

An embodiment of the present invention affords an etching method for fabricating a contact hole in an insulating layer between multi-layered wiring layers of a semiconductor device. Etching is performed by a chemical dry etching process, in which a plasma of etchant gas is formed in a separate chamber and led to the etching chamber. A substrate body with covering photo resist mask is heated up to the softening temperature of the photo resist, from its reverse side (the etching taking place at its obverse side) A pattern edge portion of the photo resist is rolled up gradually as side etching proceeds under the pattern edge, and the side walls of the contact hole formed are tapered. Consequently, the contact hole can be given good step coverage.

## Claims

1. A method of etching, for use in semiconductor device fabrication, in which a substrate body having a layer to be etched on its obverse side with a photo resist mask on the layer through which a part of the layer is exposed is

    heated from its reverse side to a temperature at which the photo resist mask is softened, and

    supplied with active etchant gas at a temperature lower than that at the obverse side of the substrate body for etching the exposed part of the layer at the obverse side such that during etching an edge of the photo resist mask around the exposed part of the layer curls upwards away from the layer.

2. A method as claimed in claim 1, wherein a plasma of etchant gas is generated in a chamber separate from a chamber in which the etching takes place, and the plasma is fed to the chamber in which the etching takes place as the active etchant gas.

3. A method as claimed in claim 1 or 2, wherein the photo resist mask is of positive photo resist material and the substrate body is so heated to a temperature in the range 120° C to 160° C.

4. A method as claimed in any one of claims 1 or 2, wherein the photo resist mask is of negative photo resist material and the substrate body is so heated to a temperature in the range 160° C to 200° C.

5. A method as claimed in any preceding claim, wherein the etchant gas comprises a mixture of tetrafluoromethane and oxygen.

6. A method as claimed in any preceding claim, wherein the layer to be etched is an insulating layer formed on a wiring layer of the substrate body, the etching forming a contact hole in the insulating layer, and a further wiring layer is subsequently formed on the insulating layer, with contact between the wiring layers through the contact hole.

## Revendications

1. Procédé d'attaque utilisable dans la fabrication des dispositifs semiconducteurs, dans lequel un corp de substrat, comportant sur sa face obverse une couche à attaquer et sur la couche un masque de résine photosensible à travers lequel une partie de la couche est exposée, est chauffé par sa face opposée à une température à laquelle le masque de résine photosensible est ramolli, et est soumis à un gaz d'attaque actif à une température inférieure à celle de la face obverse du corps de substrat pour attaquer la partie exposée de la couche sur la face obverse de manière qu'au cours de l'attaque le bord du masque de résine photosensible entourant la partie exposée de la couche s'incurve vers le haut en s'écartant de la couche.

2. Procédé selon la revendication 1, dans lequel un plasma de gaz d'attaque est produit dans une chambre séparée d'une chambre dans laquelle a lieu l'attaque, et le plasma est introduit dans la chambre dans laquelle a lieu l'attaque sous forme de gaz d'attaque actif.

3. Procédé selon la revendication 1 ou 2, dans lequel le masque de résine photosensible est en une matière de résine photosensible positive et le corps de substrat est ainsi chauffé à une température comprise entre 120 et 160°C.

4. Procédé selon l'une quelconque des revendications 1 et 2, dans lequel le masque de résine photosensible est en une matière de résine photosensible négative et le corps de substrat est ainsi chauffé à une température comprise entre 160 et 200°C.

5. Procédé selon l'une quelconque des revendications précédentes, dans lequel le gaz d'attaque comprend un mélange de tétrafluorométhane et d'oxygène.

6. Procédé selon l'une quelconque des revendications précédentes, dans lequel la couche qui doit être attaquée est une couche isolante formée sur une couche de câblage du corps de substrat, l'attaque formant un trou de contact dans la couche isolante, après quoi une autre couche de câblage est formée sur la couche isolante, avec un contact entre les couches de câblage à travers le trou de contact.

**Patentansprüche**

1. Ätzverfahren, zur Verwendung bei der Halbleitervorrichtungsfabrikation, bei welchem ein Substratkörper, der auf seiner Vorderseite eine zu ätzende Schicht mit einer Photoresistmaske auf der Schicht hat, durch welche ein Teil der Schicht exponiert wird,

von der Rückseite auf eine Temperatur erhitzt wird, bei der die Photoresistmaske erweicht wird, und

ein Aktivätzgas, bei einer Temperatur, die niedriger als die auf der Vorderseite des Substratkörpers ist, zugeführt wird, zum Ätzen des exponierten Teils der Schicht auf der Vorderseite, so daß während des Ätzens ein Rand der Photoresistmaske um den exponierten Teil der Schicht sich von der Schicht fort nach oben kräuselt.

2. Verfahren nach Anspruch 1, bei dem ein Plasma von Ätzgas in einer Kammer generiert wird, die separat von einer Kammer ist, in welcher Ätzen stattfindet, und das Plasma als das Aktivätzgas in die Kammer eingespeist wird, in der das Ätzen stattfindet.

3. Verfahren nach Anspruch 1 oder 2, bei dem die Photoresistmaske aus einem positiven Photoresistmaterial besteht, und der Substratkörper so auf eine Temperatur im Bereich von 120°C bis 160°c erhitzt wird.

4. Verfahren nach einem der Ansprüche 1 oder 2, bei dem die Photoresistmaske aus einem negativen Photoresistmaterial besteht und der Substratkörper so auf eine Temperatur im Bereich von 160°C bis 200°C erhitzt wird.

5. Verfahren nach einem der vorhergehenden Ansprüche, bei dem das Ätzgas eine Mischung aus Tetraflourmethan und Sauerstoff umfaßt.

6. Verfahren nach einem der vorhergehenden Ansprüche, bei dem die zu ätzende Schicht eine isolierende Schicht ist, die auf einer Verdrahtungsschicht des Substratkörpers gebildet ist, das Ätzen ein Kontaktloch in der isolierenden Schicht bildet und eine weitere Verdrahtungsschicht danach auf der isolierenden Schicht gebildet wird, mit Kontakt zwischen den Verdrahtungsschichten durch das Kontaktloch.

**Fig. 1**

Fig. 2

$O_2$    $CF_4$    $N_2$

Micro-wave Oscillator

Gas Flow Controller

Plasma Generator Chamber

Loading Chamber

G    S    Etching  Chamber    G

S

S

H

LC    CB    UC

Unloading Chamber

Evacuation Pump

Exhaust Duct

Fig. 3